# EUROPÄISCHE PATENTANMELDUNG

(11) **EP 1 662 264 A1**
(43) Veröffentlichungstag der Anmeldung: **31.05.2006**
(21) Anmeldenummer: 05020968.3
(22) Anmeldetag: 27.09.2005
(51) Int. Cl.: G01R 31/00, G01R 31/02

(54) **Vorrichtung zur Überwachung eines Leitungsnetzes, insbesondere eines Kraftfahrzeug-Bordnetzes sowie Verfahren zum Überwachen eines solchen Leitungsnetzes**

(30) Priorität: 27.11.2004 DE 102004057330
(71) Anmelder: Leoni Wiring Systems UK Limited, Staffordshire ST5 9BT (GB)
(72) Erfinder: Evans, Howard, CW2 5JZ Hough Grewe (GB)
(74) Vertreter: Tergau & Pohl Patentanwälte

(57) **Zusammenfassung**

Zur Überwachung eines elektrischen Leitungsnetzes insbesondere eines Kraftfahrzeuges, welches zumindest teilweise an einer Kohlefasertragstruktur (12) befestigt ist, ist eine Überwachungseinheit (14) vorgesehen, die mit der Kohlefasertragstruktur (12) an vorzugsweise mehreren Messpunkten (20) elektrisch verbunden ist. An den Messpunkten (20) werden Spannungswerte abgegriffen und mit zulässigen Spannungswerten verglichen. Übersteigen die Spannungswerte beispielsweise aufgrund eines Kurzschlusses zulässige Höchstgrenzen, so wird dies als ein Indiz für einen unzulässigen Strom über die Kohlefasertragstruktur (12) gewertet und insbesondere wird eine Energiequelle (2) vom Leitungsnetz getrennt.

## Beschreibung

Die Erfindung betrifft eine Vorrichtung und ein Verfahren zum Überwachen eines Leitungsnetzes, insbesondere eines Kraftfahrzeug-Bordnetzes.

Bei Kraftfahrzeugen gehen Entwicklungsbemühungen dahin, Teilbereiche der Karosserie oder die gesamte Fahrzeug-Karosserie als eine Kohlefasertragstruktur aus einem Kohlefaserwerkstoff auszubilden. Die besonderen Vorteile des Kohlefaserwerkstoffes liegen in seinen sehr guten mechanischen Eigenschaften und seinem geringen spezifischen Gewicht. Aufgrund seiner im Vergleich zu einer metallischen Karosserie unterschiedlichen elektrischen Eigenschaften, beispielsweise im Hinblick auf seine Leitfähigkeit oder auf die Abschirmung gegen Hochfrequenzstörungen usw. sind spezielle Lösungen erforderlich.

Bei einer Metallkarosserie wird üblicherweise die Karosserie selbst als Teil des elektrischen Stromkreises und damit als Teil des Bordnetzes eingesetzt, und wird oftmals als Masseanschluss verwendet. Aufgrund der guten Leitfähigkeit der Metallkarosserie ist dies problemlos möglich. Bei Einsatz eines Kohlefaserwerkstoffes würde eine derartige Einbindung der Karosserie in das Bordnetz jedoch zu Problemen führen. Zwar ist der Kohlefaserwerkstoff elektrisch leitfähig, jedoch weist der Werkstoff im Vergleich zu Metall eine deutlich geringere Leitfähigkeit auf. Der erhöhte Widerstand kann bei großen Strommengen zu einer erheblichen Erwärmung und damit zu einer thermischen Schädigung führen. Aufgrund des Kohleanteils besteht sogar eine Brandgefahr, falls eine zündende Energiequelle vorhanden ist.

Der Erfindung liegt die Aufgabe zugrunde, eine sichere Kombination eines Leitungsnetzes mit einer Kohlefasertragstruktur, insbesondere die Verbindung eines Kfz-Bordnetzes mit einer Kohlefaserkarosserie zu ermöglichen.

Die Aufgabe wird gemäß der Erfindung gelöst durch eine Vorrichtung gemäß den Merkmalen des Patentanspruchs 1. Danach ist vorgesehen, dass insbesondere ein Kraftfahrzeugbordnetz zumindest teilweise an einer Kohlefasertragstruktur, insbesondere eine Kohlefaserkarosserie, befestigt ist, also mechanisch mit der Tragstruktur verbunden ist. Das Bordnetz umfasst zumindest einen elektrischen Verbraucher, welcher sowohl über eine Zuleitung als auch eine Rückleitung mit einer Energiequelle verbunden ist. Um einen unzulässigen Zustand erfassen zu können, beispielsweise einen Kurzschluss oder eine defekte Leitung, ist weiterhin eine Überwachungseinheit vorgesehen, die an zumindest einem Messpunkt, vorzugsweise an mehreren voneinander beabstandeten Messpunkten, elektrisch mit der Kohlefasertragstruktur verbunden ist.

Unter zumindest teilweiser Befestigung an der Kohlefasertragstruktur wird die nur mechanische Anordnung des Bordnetzes zumindest in Teilstücken an der Kohlefasertragstruktur verstanden, welche einen potenziellen Strompfad zur oder von der Energiequelle darstellt.

Dieser Ausgestaltung liegt die Überlegung zugrunde, dass im Fehlerfall ein unzulässig hoher Stromfluss über die Kohlefasertragstruktur auftritt, was zu einer Erhöhung eines an der Kohlefasertragstruktur abgreifbaren Spannungspotenzials führt. Aufgrund der nur geringen Leitfähigkeit variiert das Spannungspotenzial in Abhängigkeit des Messortes, so dass an unterschiedlichen Messpunkten unterschiedliche Spannungswerte auftreten können. Aufgrund der Erfassung und Überwachung der Spannungspotenziale an der Kohlefasertragstruktur wird mit dieser Vorrichtung daher ein unzulässiger Stromfluss erkannt und es können geeignete Maßnahmen zur Sicherung des Bordnetzes bzw. zur Sicherung des gesamten Fahrzeugs ergriffen werden.

Zweckdienlicherweise ist ein Trennschalter zum Trennen der Energiequelle vom Leitungsnetz vorgesehen, welcher von der Überwachungseinheit ansteuerbar ist. Im Fehlerfall besteht daher die Möglichkeit, die Energiequelle, vom Leitungsnetz zu trennen und somit das gesamte Bordnetz stromlos zu schalten, um weitere Schäden zu vermeiden.

Gemäß einer bevorzugten Ausgestaltung sind Vergleichsdaten für erlaubte Messzustände hinterlegt, insbesondere in der Überwachungseinheit selbst. Die Überwachungseinheit ist zudem derart ausgebildet, dass eine Abweichung der gemessenen Werte von den erlaubten Messzuständen als ein Fehlzustand bewertet wird. In diesem Fall erzeugt dann die Überwachungseinheit ein Fehlersignal, insbesondere ein Abschaltsignal an den Trennschalter zum Trennen der Energiequelle. Dieser Ausgestaltung liegt die Überlegung zugrunde, dass im normalen Betriebszustand durchaus geringe Ströme über die Kohlefasertragstruktur fließen können, die beispielsweise darauf zurückzuführen sind, dass Verbraucher mit ihren metallischen Gehäusen unmittelbar an der Kohlefasertragstruktur angeordnet sind und das Gehäuse den Masseanschluss bildet. Es stellen sich daher zulässige Spannungswerte über die Kohlefasertragstruktur hinweg an dieser ein. Die an einer bestimmten Position auftretende Höhe der zulässigen Spannungswerte hängt von dem jeweiligen aktuellen Zustand der Verbraucher ab. Die Zustände bestimmen sich dabei insbesondere danach, ob die einzelnen Verbraucher ein- oder ausgeschaltet und mit welcher Last sie betrieben werden. Insgesamt sind je nach Zustand daher eine Vielzahl von erlaubten Spannungs- und Messzuständen möglich, so dass die Vergleichsdaten für die erlaubten Messzustände sich in Hüllkurven für den zulässigen Messwert darstellen lassen. Derartige Hüllkurven sind daher vorzugsweise in der Überwachungseinheit hinterlegt.

Die Überwachungseinheit ist in einer vorteilhaften Weiterbildung an einen Datenbus angeschlossen, über den sie Informationen über die aktuelle Situation der Verbraucher des Bordnetzes erhält. In Abhängigkeit der übermittelten aktuellen Situation ermittelt die Überwachungseinheit die zu erwartenden Messzustände.

Zweckdienlicherweise wird der zu erwartende Messzustand unmittelbar dem insbesondere als Hüllkurven hinterlegten Vergleichsdaten entnommen, die beispielsweise auch in einer Tabelle hinterlegt sein können. Durch diese Maßnahme ist eine genaue und an die aktuelle Situation angepasste Bestimmung der zulässigen Werte ermöglicht, so dass die Bestimmung, ob ein Fehlzustand vorliegt oder nicht, mit größerer Genauigkeit getroffen werden kann, wodurch insgesamt die Zuverlässigkeit des Systems erhöht ist.

In einer zweckdienlichen Weiterbildung erhält die Überwachungseinheit zusätzlich Informationen über den von zumindest einem weiteren Sensor, beispielsweise einen Aufprallsensor, erfassten Fahrzeugzustand. Diese Informationen werden ausgewertet und bei einem unzulässigen Fahrzeugzustand wird insbesondere der Trennschalter angesteuert. Die Überwachungseinheit ist daher nach Art einer zentralen Überwachungseinheit ausgebildet, bei der mehrere sicherheitsrelevante Informationen zusammenlaufen, wobei in der Überwachungseinheit die Entscheidung getroffen wird, ob die Batterie vom Netz getrennt wird oder nicht. Insbesondere bei Unfällen ist die möglichst unverzügliche Trennung der Batterie ein wesentliches Sicherheitsmerkmal um Folgeschäden nach einem Unfall zu vermeiden, beispielsweise durch Entzünden von auslaufendem Benzin.

Die Aufgabe wird gemäß der Erfindung weiterhin gelöst durch ein Verfahren zum Überwachen eines Leitungsnetzes gemäß Patentanspruch 6. Bevorzugte Ausgestaltungen des Verfahrens sind in den Unteransprüchen niedergelegt. Die im Hinblick auf die Vorrichtung angeführten Vorteile und bevorzugten Ausgestaltungen sind sinngemäß auch auf das Verfahren zu übertragen.

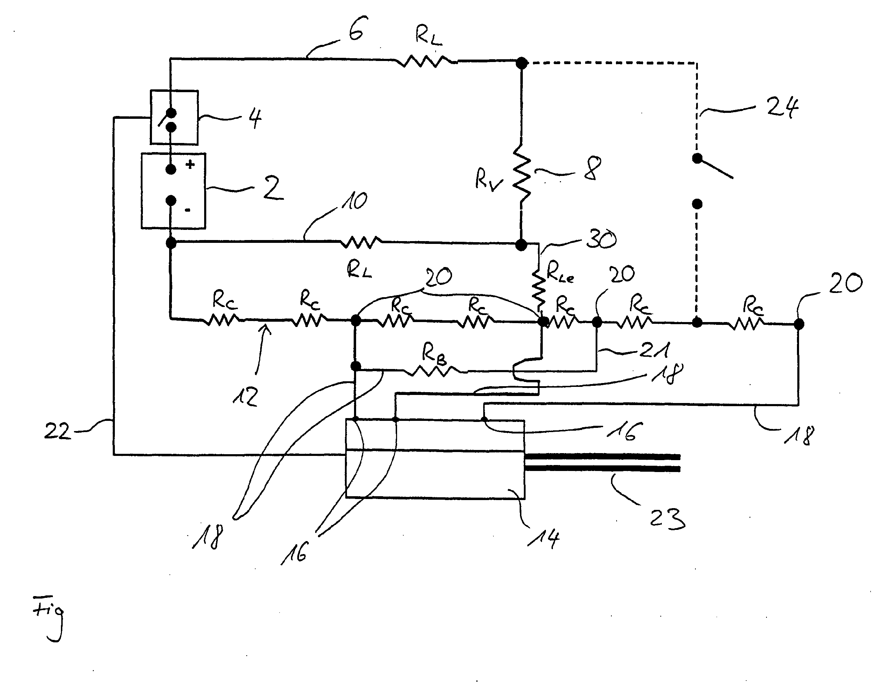

Ein Ausführungsbeispiel der Erfindung wird im Folgenden anhand der einzigen Figur erläutert. Diese zeigt in schematischer und stark vereinfachter Darstellung einen Ausschnitt aus einem Leitungsnetz insbesondere eines Kraftfahrzeugs, welches zumindest in Teilbereichen eine Kohlefasertragstruktur aufweist, die mit dem Bordnetz zumindest teilweise in mechanischem Kontakt steht, also Berührungspunkte aufweist.

Gemäß der einzigen Figur umfasst ein Kraftfahrzeug-Bordnetz, eine als Batterie ausgebildete Gleichstrom-Energiequelle 2, einen dieser am Plus-Pol nachgeschalteten Trennschalter 4, eine elektrische Zuleitung 6, die den Plus-Pol der Energiequelle 2 mit einem elektrischen Verbraucher 8 verbindet, sowie eine eigenständige elektrische Rückleitung 10, die mit dem Minus-Pol der Energiequelle 2 verbunden ist. Sowohl die Zuleitung 6 als auch die Rückleitung 10 sind als separat verlegte Leitungen ausgebildet. Im Kraftfahrzeug-Bordnetz sind üblicherweise eine Vielzahl von Verbrauchern 8 angeordnet.

In der Figur ist eine Kohlefasertragstruktur 12 als eine parallel zur Rückleitung 10 verlaufende elektrische Verbindung zur Energiequelle 2 dargestellt. Physikalisch bedeutet dies, dass ein potentieller elektrischer Pfad vom Verbraucher 8 zur Energiequelle 2 besteht, der zumindest in Teilstrecken über die Kohlefasertragstrucktur 12 verläuft. Weiterhin ist eine Überwachungseinheit 14 vorgesehen, die im Ausführungsbeispiel insgesamt drei Überwachungseingänge 16 aufweist. Von diesen führen Überwachungsleitungen 18 zu verschiedenen Messpunkten 20 an der Kohlefasertragstruktur 12. An den Messpunkten 20 wird die dort an der Kohlefasertragstruktur 12 anliegende Spannung abgegriffen. Weiterhin ist in der schematischen Darstellung eine Überbrückungsleitung 21 dargestellt, welche beispielsweise gebildet ist durch eine metallische Komponente, die unmittelbar mit der Kohlefasertragstruktur 12 verbunden ist und dazu führt, dass die über die Überbrückung miteinander verbundenen Punkte der Kohlefasertragstruktur 12 auf gleichem Potenzial liegen.

Die Überwachungseinheit 14 weist ausgangsseitig einen Steuerausgang auf, welcher über eine Steuerleitung 22 mit dem Trennschalter 4 verbunden ist. Zudem ist sie eingangsseitig an einem Datenbus 23 angeschlossen. Ihre Energie bezieht die Überwachungseinheit 14 aus der Energiequelle 2 oder aus einer separaten Energiequelle.

Parallel zum elektrischen Verbraucher 8 ist ein Schalter dargestellt, der einen möglichen Kurzschluss über einen gestrichelt dargestellten Kurzschlusspfad 24 andeutet.

In den einzelnen Strompfaden sowie in der Kohlefasertragstruktur 12 sind unterschiedliche Widerstände angedeutet. R_{L} ist dabei der Leitungswiderstand der Zuleitung 6 bzw. Rückleitung 10, R_{V} ist der Verbraucherwiderstand, R_{C} ist jeweils ein Teilwiderstand der Kohlefasertragstruktur 12 und R_{B} ist der Widerstand der Überbrückungsleitung 26 ist. Aufgrund der nur geringen Leitfähigkeit lässt sich der Gesamtwiderstand der Kohlefasertragstruktur 12 als Summe vieler einzelner verteilter Teilwiderstände R_{c} darstellen.

Zwischen der Rückleitung 10 und der Kohlefasertragstruktur 12 ist weiterhin eine elektrische Verbindung dargestellt, welche einen Leckpfad 30 mit einem Leckwiderstand R_{Le} bildet. Dieser Leckpfad 30 ist ein potenzieller Strompfad zurück zur Energiequelle 2 durch die Karosseriestruktur 12. Dieser potenzielle Strompfad wird durch den dichten mechanischen Einbau des Verbrauchers 8 an der Kohlefasertragstruktur 12 gebildet. Üblicherweise werden nämlich die Metallgehäuse der Verbraucher 8, mit denen sie auf der Karosseriestruktur 12 befestigt sind, zugleich zur Verbesserung der Abschirmleistung mit Masse, also mit dem Minus-Pol der Energiequelle 2, verbunden.

Im normalen Zustand wird bei eingeschaltetem Verbraucher 8 der Strom fast ausschließlich über die Zuleitung 6 und die Rückleitung 10 fließen, da der Leitungswiderstand R_{L} sehr klein ist und typischerweise in der Größenordnung von Milli-Ohm (mΩ) liegt. Demgegenüber liegt der Widerstandswert von R_{c} bei einigen hundert mΩ bis zu mehreren Ohm pro Quadratmillimeter. Der Verbraucherwiderstand Rᵥ liegt typischerweise im Bereich von einem Ohm. Der Widerstand der Überbrückungsleitung R_{B} liegt in der gleichen Größenordnung wie der Leitungswiderstand R_{L} und ist damit deutlich kleiner als der Widerstand des Kohlefaserwerkstoffs R_{c}.

Bereits im normalen Betrieb kann über den Leckpfad 30 und die Kohlefaserstruktur 12 ein kleiner Leckstrom fließen, welcher jedoch noch nicht sicherheitskritisch ist. In der Kohlefasertragstruktur 12 bildet sich daher eine Potenzialverteilung aus, so dass an den unterschiedlichen Messpunkten 20 unterschiedliche Spannungswerte anliegen, welche über die Überwachungseinheit 14 gemessen und ausgewertet werden. Je nach Anzahl der Verbraucher 8, die aktuell eingeschaltet sind, sowie in Abhängigkeit des jeweiligen Lastzustands der unterschiedlichen Verbraucher 8 stellen sich über die Kohlefasertragstruktur 12 verteilt unterschiedliche erlaubte Potenzialzustände bereits im normalen Betrieb ein. Diese erlaubten zulässigen Potenzialzustände sind in der Überwachungseinheit 14 als Vergleichsdaten für jeden der einzelnen Messpunkte 20 hinterlegt. Die aktuellen Zustandsdaten der Verbraucher 8 werden der Überwachungseinheit 14 über den Datenbus 23 beispielsweise von einer zentralen Steuereinheit übermittelt.

Zur Überwachung des Bordnetzes werden kontinuierlich oder in diskreten Zeitabständen die Spannungswerte an den Messpunkten 20 erfasst und ausgewertet. Weichen die gemessenen Spannungswerte von den hinterlegten Vergleichswerten oder Vergleichsdaten in unzulässiger Weise ab, so wird dies als ein Fehlzustand erfasst und die Überwachungseinheit 14 gibt ein entsprechendes Fehlersignal am Steuerausgang über die Steuerleitung 22 aus. Ein derartiges Fehlersignal ist beispielsweise ein akustisches oder optisches Signal, um den Fahrzeughalter zu warnen. Altemativ hierzu ist vorgesehen, dass als Fehlersignal ein Abschaltsignal an den Trennschalter 4 übermittelt wird, so dass die Energiequelle 2 vom Leitungsnetz getrennt wird und das gesamte Bordnetz spannungsfrei geschalten wird. Eine derartige Trennung wird insbesondere bei schweren Störungen vorgenommen. Hierbei kann vorgesehen sein, dass gewisse Notfunktionalitäten zunächst noch aufrecht erhalten werden, um das Fahrzeug beispielsweise noch bis in die nächste Werkstatt fahren zu können. Es können daher auch mehrere Trennschalter 4 vorgesehen sein, über die nur Teile des Bordnetzes abgeschaltet werden.

Die Messpunkte 20 sind beispielsweise in vorhandene Verbraucher 8 und deren leitfähige Geräte integriert, die an der Kohlefasertragstruktur 12 befestigt sind. Alternativ hierzu kann es sich bei den Messpunkten 20 auch um spezifisch für diesen Zweck eingerichtete Sensoranschlüsse handeln.

Mit der Überwachungseinheit 14 wird daher zwischen den normalen, zu erwartenden Potenzialwerten und anormalen, fehlerbedingten Potenzialwerten unterschieden und es werden geeignete Maßnahmen, insbesondere das Abschalten der Energiequelle 2, ausgeführt.

Der Fehlerfall wird beispielsweise durch den als Kurzschlusspfad 24 angezeigten Kurzschluss zwischen dem Bordnetz und der Kohlefasertragstruktur 12 hervorgerufen. Aufgrund des Kurzschlusses wird über die Kohlefasertragstruktur 12 ein unzulässig hoher Strom fließen, der eine Gefahrenquelle darstellt und unter Umständen zu einem Brand führen kann. Da die Kohlefasertragstruktur 12 insgesamt einen vergleichsweise hohen Widerstand bildet, besteht bei Auftreten eines Kurzschlusses die Gefahr, dass eine eventuell vorhandene Sicherung nicht anspricht und dass daher der Kurzschluss unentdeckt bleibt. Aufgrund der Überwachungseinheit werden nunmehr die aufgrund des Kurzschlusses erhöhten Spannungswerte als Fehlzustände erfasst und es können geeignete Maßnahmen getroffen werden.

Eine weitere mögliche Fehlerquelle ist die Beschädigung der Rückleitung 10. In diesem Fall erfolgt die Verbindung mit dem Minus-Pol der Energiequelle 2 nicht über die Rückleitung 10, sondern über den Leckpfad 30 und über die Kohlefasertragstruktur 12, welche dann den Primärstrompfad bilden. Üblicherweise ist der Leckwiderstand R_{Le} viel größer als der Verbraucherwiderstand R_{L}, so dass aufgrund des Spannungsteilereffekts eine effektive Energiequelle unmittelbar durch die Kohlefasertragstruktur 12 angenommen werden kann, d.h. nahezu die gesamte anliegende Spannung fällt über die Kohlefasertragstruktur 12 ab. Daher wird der über den Leckpfad 30 fließende Strom im Vergleich zum Normalfall deutlich ansteigen und kann unter Umständen vergleichbare Werte wie im Kurzschlussfall annehmen. Auch in diesem Fall wird sich das Spannungspotenzial an den Messpunkten 20 im Vergleich zum fehlerfreien Normalzustand erhöhen, so dass der Fehler erkannt und die Energiequelle 2 abgeschaltet werden kann.

Die Überwachungseinheit 14 ist vorzugsweise eine zentrale Überwachungseinheit, der über den Datenbus 23 neben Informationen über die aktuellen Zustände der einzelnen Verbraucher 8 noch weitere zusätzliche Informationen von weiteren, hier nicht näher dargestellten Sensoren, übermittelt werden. Derartige Sensoren sind beispielsweise so genannte Crash-Sensoren, die bei einem Unfall ansprechen. Falls ein derartiges Signal vorliegt, gibt die Überwachungseinheit ebenfalls ein Fehlersignal ab, insbesondere steuert sie den Trennschalter 4 zum Abschalten der Energiequelle 2 an.

Bezugszeichenliste
- 2: Energiequelle
- 4: Trennschalter
- 6: Zuleitung
- 8: elektrischer Verbraucher
- 10: Rückleitung
- 12: Kohlefasertragstruktur
- 14: Überwachungseinheit
- 16: Überwachungseingang
- 18: Überwachungsleitung
- 20: Messpunkt
- 21: Überbrückungsleitung
- 22: Steuerleitung
- 23: Datenbus
- 24: Kurzschlusspfad
- 30: Leckpfad

- R_{L}: Leitungswiderstand
- R_{V}: Verbraucherwiderstand
- R_{C}: verteilter Widerstand der Kohlefasertragstruktur
- R_{B}: Widerstand der Überbrückungsleitung
- R_{Le}: Widerstand des Leckpfads

## Patentansprüche

1. Vorrichtung zur Überwachung eines Leitungsnetzes, insbesondere eines Kfz-Bordnetzes, welches zumindest teilweise an einer Kohlefasertragstruktur (12) befestigt ist und das einen elektrischen Verbraucher (8) über eine Zuleitung (6) sowie eine Rückleitung (10) mit einer Energiequelle (2) verbindet, wobei eine Überwachungseinheit (14) vorgesehen ist, die mit der Kohlefasertragstruktur (12) an zumindest einem Messpunkt (20) elektrisch verbunden ist.

2. Vorrichtung nach Anspruch 1, bei der ein Trennschalter (4) zum Trennen der Energiequelle (2) vom Leitungsnetz vorgesehen ist, welcher von der Überwachungseinheit (14) ansteuerbar ist.

3. Vorrichtung nach Anspruch 1 oder 2, bei der Vergleichsdaten für erlaubte Messzustände hinterlegt sind und die Überwachungseinheit (14) derart ausgebildet ist, dass eine Abweichung von den erlaubten Messzuständen als ein Fehlzustand bewertet wird.

4. Vorrichtung nach einem der vorhergehenden Ansprüche, bei der die Überwachungseinheit (14) an einen Datenbus (23) angeschlossen ist, über den sie Informationen über die aktuelle Situation des Verbrauchers (8) des Bordnetzes erhält und derart ausgebildet ist, dass sie aus diesen Informationen die zu erwartenden Messzustände ermittelt.

5. Vorrichtung nach einem der Ansprüche 2 bis 4, bei der die Überwachungseinheit (14) zusätzlich Informationen über den Fahrzeugzustand erhält und die Überwachungseinheit (14) derart ausgebildet ist, dass bei einem unzulässigen Fahrzeugzustand der Trennschalter (4) angesteuert wird.

6. Verfahren zum Überwachen eines Leitungsnetzes, insbesondere eines Kfz-Bordnetzes, welches zumindest teilweise an einer Kohlefasertragstruktur (12) befestigt ist und das einen elektrischen Verbraucher (8) über eine Zuleitung (6) sowie eine Rückleitung (10) mit einer Energiequelle (2) verbindet, wobei mit Hilfe einer Überwachungseinheit (14) zumindest an einem Messpunkt (20) an der Kohlefasertragstruktur (12) ein Spannungswert abgegriffen und ausgewertet wird.

7. Verfahren nach Anspruch 6, bei dem die Energiequelle (2) vom Leitungsnetz getrennt wird, sobald ein unzulässiger Zustand erfasst wird.

8. Verfahren nach Anspruch 6 oder 7, bei dem die Überwachungseinheit (14) die Messwerte mit Vergleichsdaten für erlaubte Messzustände vergleicht und bei einer Abweichung von den erlaubten Messzuständen ein Fehlersignal abgibt.

9. Verfahren nach einem der Ansprüche 6 bis 8, bei dem die Überwachungseinheit (14) über einen Datenbus (23) Informationen über die aktuelle Situation der Verbraucher (8) des Bordnetzes erhält und hieraus die zu erwartenden erlaubten Messzustände ermittelt.

10. Verfahren nach einem der Ansprüche 6 bis 9, bei dem die Überwachungseinheit (14) zusätzlich Informationen über den Fahrzeugzustand erhält und bei einem unzulässigen Fahrzeugzustand die Energiequelle (2) vom Leitungsnetz trennt.
